# EUROPÄISCHE PATENTSCHRIFT

(11) **EP 0 808 462 B1**
(45) Veröffentlichungstag und Bekanntmachung des Hinweises auf die Patenterteilung: **14.10.1998**
(21) Anmeldenummer: 96900884.6
(22) Anmeldetag: 24.01.1996
(51) Int. Cl.: G01R 31/327, H02H 1/00

(54) **MESSSYSTEM FÜR GEKAPSELTE HOCHSPANNUNGSSCHALTANLAGEN**
MEASURING SYSTEM FOR ENCLOSED HIGH-VOLTAGE SWITCHGEAR
SYSTEME DE MESURE POUR APPAREILLAGE DE COMMUTATION HAUTE TENSION BLINDE

(30) Priorität: 06.02.1995 DE 19504731
(43) Veröffentlichungstag der Anmeldung: 26.11.1997
(73) Patentinhaber: SIEMENS AKTIENGESELLSCHAFT, 80333 München (DE)
(72) Erfinder: ACHATZ, Norbert, D-12163 Berlin (DE); GORABLENKOW, Jörg, D-13591 Berlin (DE)
(86) Internationale Anmeldenummer: DE9600148
(87) Internationale Veröffentlichungsnummer: WO9624856

(56) Entgegenhaltungen:
- EP-A- 0 342 597
- PROC. 1991 IEEE POWER ENGINEERING SOCIETY, TRANSMISSION AND DISTRIBUTION CONF., 22. - 27.September 1991, DALLAS, Seiten 467-472, XP000302464 BRAUN ET AL.: "RELIABILITY OF GIS EHV EPOXY INSULATORS: THE NEED AND PROSPECTS..."

## Beschreibung

Die Erfindung bezieht sich auf ein Meßsystem für Störsignale in Form von elektromagnetischen Wellen in gekapselten Hochspannungsschaltanlagen, die wenigstens zwei einphasig gekapselte Pole aufweisen, welches wenigstens einen Sensor für jede Phase zur Erfassung von Störsignalen und eine mit den Sensoren verbundene Detektoreinrichtung zur Ausgabe eines Signals im Falle einer Störung aufweist.

Eine gekapselte Hochspannungsschaltanlage mit einphasig gekapselten Polen und mit einem Meßsystem für Störungen in Form von elektromagnetischen Wellen ist beispielsweise aus dem Artikel "Operation and Diagnosis Assisting System for Substations", Hitachi-Review Vol. 40, 1991 No. 5, Seiten 359 bis 366 bekannt. Bei dem dort beschriebenen Meßsystem wird mittels eines Sensors ein Störsignal erfaßt und dieses wird mittels einer Spektralanalyse weiter untersucht, um näheren Aufschluß über die Natur der Störung innerhalb der gekapselten Hochspannungsschaltanlage zu erhalten.

Bei einem solchen Meßsystem gibt es viele Fehlerquellen und die Wahrscheinlichkeit eines Fehlers steigt mit der Anzahl der Sensoren.

Aus der EP-A-0 342 597 ist ein Meßsystem für gekapselte Hochspannungsschaltanlagen bekannt, bei dem mehrere gleichartige oder verschiedenartige Sensoren zur Erfassung von Teilentladungsvorgängen vorgesehen sind, deren Meßwerte in bezug auf die Intensität und den Zeitpunkt bzw. die Zeitdauer ihres Auftretens analysiert werden. Bei einem großen Unterschied zweier miteinander verglichener Meßwerte wird auf das Vorliegen eines Fehlers in der Anlage geschlossen.

Ein solcher großer Unterschied kann auch dadurch auftreten, daß nur ein einziger Meßwert registriert und ein zweiter entsprechend gleich Null angenommen wird. Dies könnte auch dann eintreten, wenn zwei Meßwerte von verschiedenen Sensoren mit einer großen Zeitdifferenz registriert werden. Auf diese Weise können gegebenenfalls überflüssige Fehlermeldungen erzeugt werden.

Aus dem Fachartikel ,,Proceedings of the 1991 IEEE Power Engineering Society, Transmission and Distribution Conference", 22.-27.9.1991, Seiten 467-472 ist es bekannt, bei Differentialmessungen an Hochspannungsschaltanlagen Ungleichmäßigkeiten der elektrischen Längen zwischen den Sensoren und der Verarbeitungseinrichtung auszugleichen.

Der vorliegenden Erfindung liegt die Aufgabe zugrunde, für gekapselte Hochspannungsschaltanlagen der eingangs genannten Art das Meßsystem bei möglichst einfachem, kostengünstigem Aufbau möglichst störungssicher zu gestalten.

Die Aufgabe wird erfindungsgemäß gelöst durch eine Zeitvergleichseinrichtung, die die unmittelbare, ohne Durchlaufen anderer Analysestationen erfolgende Ausgabe eines Signals sperrt, falls die Zeitdifferenz des Eintreffens zweier Störsignale von Sensoren verschiedener Phasen bei der Detektoreinrichtung eine bestimmte, insbesondere einstellbare Zeitspanne unterschreitet.

Der Erfindung liegt die Tatsache zugrunde, daß viele Störsignale, die innerhalb einer gekapselten Schaltanlage in Form von elektromagnetischen Wellen in Erscheinung treten, nicht innerhalb der Schaltanlage durch Teilentladungen oder Schaltvorgänge oder bewegliche Partikel entstehen, sondern von außerhalb der Anlagenkapselung eingestrahlt werden, beispielsweise durch Radarsender. Solche äußeren Einflüsse produzieren Störsignale, die jedoch nicht auf wirkliche Fehler in der Anlage zurückzuführen sind und daher bei einer Störungsüberwachung ausgesondert werden sollen.

Solche Störsignale werden meistens an singulären Punkten der Anlagenkapselung, beispielsweise Freiluftdurchführungen mit großen Isolatorkörpern eingestrahlt. Es ergibt sich dabei, daß in den meisten Fällen eine Einstrahlung in mehrere Kapselungsgehäuse unterschiedlicher Pole stattfindet, so daß Störungen nahezu gleichzeitig auf mehreren Polen nachgewiesen werden. Umgekehrt kann das nahezu gleichzeitige Vorhandensein von Störungen bei mindestens zwei unterschiedlichen Phasen einer Hochspannungsschaltanlage mit hoher Wahrscheinlichkeit auf eine Einstrahlung von außen zurückgeführt werden, so daß trotz der Störsignale davon ausgegangen werden kann, daß die Schaltanlage störungsfrei funktioniert.

Ein aussagekräftiges Entscheidungskriterium für das Vorliegen einer Einstrahlung von außerhalb der Schaltanlage kann beispielsweise darin bestehen, daß zwei Störsignale in einem zeitlichen Abstand von weniger als einer Mikrosekunde auf unterschiedlichen Phasen detektiert werden.

Von dem erfindungsgemäßen Meßsystem wird ein Störsignal mittels eines Sensors, beispielsweise eines Teilentlandungsmeßsensors in Form einer Antenne nachgewiesen und der Detektoreinrichtung zugeführt. Diese gibt ein Signal mit einer Zeitverzögerung weiter, die beispielsweise eine Mikrosekunde beträgt, da zunächst abgewartet werden muß, ob innerhalb dieser Mikrosekunde weitere Störsignale eintreffen.

Ist dies nicht der Fall, so wird von der Detektoreinrichtung ein Signal unmittelbar an eine Auswerteeinrichtung für eine weitere Bewertung des Störsignals mit einer Warneinrichtung, beispielsweise eine Warnleuchte, ausgegeben. Die Detektoreinrichtung kann auch mittels einer Schutzschaltung beispiglsweise einen Leistungsschalter blockieren oder gegebenenfalls betätigen.

Treten zwei Signale auf verschiedenen Phasen innerhalb der Zeitspanne, beispielsweise innerhalb einer Mikrosekunde auf, so wird die unmittelbare Ausgabe eines Signals gesperrt. Die registrierten Signale können in diesem Fall jedoch innerhalb der Detektoreinrichtung weiterverarbeitet und beispielsweise in einer Intensitätsvergleichseinrichtung auf ihr Intensitätsverhältnis untersucht werden. Die Signale werden jedoch nicht von der Zeitvergleichseinrichtung unmittelbar, d. h. ohne Durchlaufen anderer Analysestationen, ausgegeben.

Durch das erfindungsgemäße Meßsystem können also bestimmte Fehlermeldungen mittels der Zeitvergleichseinrichtung verhindert werden, wenn diesen kein anlageninterner Fehler zugrundeliegt.

Eine vorteilhafte Ausgestaltung der Erfindung sieht vor, daß die Detektoreinrichtung eine Intensitätsvergleichseinrichtung enthält, an die die Zeitvergleichseinrichtung die Störsignale weiterleitet, wenn die Zeitdifferenz des Eintreffens zweier Störsignale der unterschiedlichen Phasen bei der Detektoreinrichtung kleiner ist als die Zeitspanne, und die einen Komparator zum Vergleich der Intensitäten der verschiedenen Störsignale enthält, welcher die Ausgabe eines Signals bewirkt, falls das Intensitätsverhältnis des größten Störsignals zu jedem der übrigen von den Sensoren erfaßten Störsignale einen bestimmten, insbesondere einstellbaren Faktor überschreitet.

In dem Fall, daß eine Störung von außen in die Kapselung der Hochspannungsschaltanläge eingekoppelt worden ist und dementsprechend zwei Störsignale auf unterschiedlichen Phasen mit geringer Zeitverzögerung auftreten, werden die Störsignale sich in ihrer Intensität höchstens um einen bestimmten, bekannten Faktor unterscheiden. Entsteht dagegen eine Störung innerhalb der Kapselung einer bestimmten Phase, so wird eine Überkopplung auf die anderen Phasen nur mit einer erheblichen Dämpfung stattfinden und entsprechend werden auf den verschiedenen Phasen zwar mehrere Störungssignale mit geringer Zeitverzögerung, jedoch mit sehr großem Intensitätsunterschied auftreten.

Daher ist es sinnvoll, auch bei annähernd gleichzeitigen Störsignalen durch das Meßsystem ein Signal auszugeben, wenn die Intensitäten von annähernd gleichzeitigen Störsignalen auf unterschiedlichen Phasen sich wenigstens um einen bestimmten, insbesondere einstellbaren Faktor unterscheiden, da dies mit hoher Wahrscheinlichkeit auf eine Störung innerhalb der Schaltanlage hindeutet.

Zur besseren Verarbeitbarkeit der Störsignale durch die Sensoren kann es außerdem vorteilhaft sein, daß jedem Sensor ein Frequenzumsetzer zur Umsetzung eines Hochfrequenzsignals in ein Niederfrequenzsignal nachgeschaltet ist.

Die typischen Teilentladungsstörsignale innerhalb der Kapselung einer Hochspannungsschaltanlage enthalten Frequenzanteile im Hochfrequenzbereich mit hoher Intensität. Zur Bewertung von Störungen reicht aber oft die Kenntnis der Gesamtintensität des Signals aus. Zu diesem Zweck wird mittels eines Frequenzumsetzers das Hochfrequenzsignal in ein Niederfrequenzsignal umgesetzt, das beispielsweise die Einhüllende des Hochfrequenzsignals darstellen kann.

Außerdem können die Störsignale besonders einfach weiterverarbeitet werden, wenn jedem Frequenzumsetzer ein Intensitätsdetektor nachgeschaltet ist.

Da die Informationen über die Störsignale dann in vereinfachter Form als Spitzenwert oder Intensitätswert vorliegen und verarbeitet werden können, können die Prozeduren des Vergleichens, der Zeitmessung und der Entscheidung bzw. Betätigung von bestimmten Stellgliedern beispielsweise unter Verwendung eines Analog/Digital-Wandlers in einfacher und kostengünstiger Form vorgenommen werden.

Die Erfindung bezieht sich außerdem auf ein Verfahren zur Erfassung von Störsignalen in Form von elektromagnetischen Wellen in einer wenigstens zweipoligen, einphasig gekapselten Hochspannungsschaltanlage mittels eines Meßsystems, wobei mittels einer mit Sensoren, welche unterschiedlichen Phasen zugeordnet sind, verbundenen Detektoreinrichtung die Ausgabe eines Signals bewirkt wird, wenn wenigstens einer der Sensoren ein Störsignal abgibt, und wobei von einer Zeitvergleichseinrichtung die unmittelbare, ohne Durchlaufen anderer Analysestationen erfolgende Ausgabe eines Signals gesperrt wird, wenn die Zeitdifferenz des Eintreffens zweier Störsignale von verschiedenen Phasen bei der Detektoreinrichtung eine bestimmte, insbesondere einstellbare Zeitspanne unterschreitet.

Eine vorteilhafte Ausgestaltung dieses Verfahrens sieht vor, daß in dem Fall, daß die Zeitdifferenz des Eintreffens zweier Störsignale der verschiedenen Phasen bei der Detektoreinrichtung eine einstellbare Zeitspanne unterschreitet, die Intensitäten der betreffenden Störsignale miteinander verglichen werden und daß in dem Fall, daß das Intensitätsverhältnis des größten der Störsignale zu jedem der übrigen von den Sensoren erfaßten Störsignale einen bestimmten, insbesondere einstellbaren Faktor überschreitet, unabhängig von der Zeitdifferenz ein Signal ausgegeben wird.

Im folgenden wird die Erfindung anhand eines Ausführungsbeispiels in einer Zeichnung gezeigt und anschließend beschrieben.

Dabei zeigt die
Figur eine Ausgestaltung des Meßsystems in einer schematischen Darstellung.

Eine metallgekapselte Hochspannungsschaltanlage weist drei Hochspannung führende Pole 1, 2, 3 auf, die jeweils einphasig gekapselt sind, d. h. jeweils eine eigene Metallkapselung 17, 18, 19 aufweisen.

Innerhalb jeder der Metallkapselungen 17, 18, 19 ist jeweils mindestens ein Sensor 5, 6, 7 oder eine Gruppe von Sensoren angeordnet, die beispielsweise als Teilentladungssensoren in Form von Antennen ausgebildet sein können.

Jeder der Pole weist einen Hochspannungsleiter auf, der mit nicht dargestellten Schalteinrichtungen, beispielsweise Trenn- und Leistungsschaltern verbunden ist.

Eine Fehlfunktion innerhalb der Schaltanlage, beispielsweise im Bereich eines Schalters oder eines Isolators, der durch Teilentladungen beschädigt werden kann, ruft im allgemeinen Störsignale in Form von elektromagnetischen Wellen hervor, die sich innerhalb jeder einzelnen Metallkapselung ausbreiten und durch die Sensoren 5, 6, 7 nachweisbar sind. Das zeitliche Verhalten bzw. das Frequenzspektrum einer solchen Störung gibt nähere Aufschlüsse über die Natur des Vorgangs, durch den die Störung hervorgerufen worden ist.

Zur einfacheren Datenverarbeitung ist jedem der Sensoren 5, 6, 7 ein Frequenzumsetzer 11, 12, 13 nachgeschaltet, der das Signal mit großen hochfrequenten Anteilen in ein niederfrequentes Signal umsetzt. Dieses niederfrequente Signal erlaubt noch eine hinreichend genaue Analyse der Störung.

Nach dieser Signalumformung durchläuft ein von dem jeweiligen Sensor 5, 6, 7 kommendes Signal jeweils einen Digital-Analog-Wandler 14, 15, 16, mit einem diesen vorgeschalteten Peah-Detektor, wo eine Peah-Detektion und Digitalisierung des Signals vorgenommen wird.

Die Digital-Analog-Wandler 14, 15, 16 sind mit einer Detektoreinrichtung 4 des Meßsystems verbunden.

Jedem der Sensoren 5, 6, 7 ist ein Speicher 20, 21, 22 zugeordnet, von denen jeder mit einer Zeiterfassungseinrichtung 23 verbunden ist. In dem jeweiligen Speicher 20, 21, 22 wird das jeweils ankommende Signal von dem entsprechenden Sensor 5, 6, 7 zusammen mit dem Zeitpunkt des Eintreffens des Signals gespeichert.

Die Speicher 20, 21, 22 sind mit der Zeitvergleichseinrichtung 8 verbunden, die die Speicher 20, 21, 22 ausliest und beim Vorliegen von wenigstens zwei Störsignalen die jeweiligen Zeitpunkte des Eintreffens der Signale miteinander vergleicht.

In die Zeitvergleichseinrichtung 8 kann über eine Zeiteingabevorrichtung 24 eine bestimmte Zeitspanne, beispielsweise eine Mikrosekunde eingegeben werden, die für die Entscheidung maßgeblich ist, ob zwei Störsignale zeitlich weit genug voneinander entfernt sind oder nicht.

Nachdem ein Störsignal in einem der Speicher eingetroffen ist, wird von der Zeitvergleichseinrichtung 8 wenigstens eine Zeitspanne abgewartet, die der eingegebenen Zeitspanne entspricht, um sicherzustellen, daß nicht ein zweites Störsignal eintrifft, bevor die Zeitspanne vorüber ist.

Trifft innerhalb der Zeitspanne ein zweites Signal aus einer der anderen Phasen ein, so gibt die Zeitvergleichseinrichtung 8 die beiden Signale an die Intensitätsvergleichseinrichtung 9 ab. In diesem Fall wird von der Zeitvergleichseinrichtung 8 kein Signal direkt an eine Einrichtung 25, 26, 27 zur weiteren Bewertung der Signale und gegebenenfalls Ausgabe eines Warnsignals ausgegeben.

Nur in dem Fall, daß ein Störsignal innerhalb eines der Speicher 20, 21, 22 vorliegt und innerhalb der eingestellten Zeitspanne kein weiteres Störsignal in einem der anderen beiden Kanäle eintrifft, entscheidet die Zeitvergleichseinrichtung 8, daß eine interne Störung vorliegt und gibt ein Signal an eine der Einrichtungen 25, 26, 27 ab, die beispielsweise Warnleuchten beinhalten können. Außerdem kann in diesem Fall ein Signal an einen der Sicherheitsschalter 28, 29, 30 ausgegeben werden, die jeweils die Auslösevorrichtungen eines Hochspannungsschalters blockieren oder einen Hochspannungsschalter betätigen können.

Außerdem wird gleichzeitig zur genaueren Diagnose der Störung jeweils ein Signal an eine Analyseeinrichtung 31 abgegeben. Dort kann das jeweilige Störungssignal dargestellt und ggf. mittels spezieller Analysemethoden weiterverarbeitet werden.

Werden in den Speichern 20, 21; 22 wenigstens zwei Störsignale innerhalb der eingestellten Zeitspanne, beispielsweise innerhalb einer Mikrosekunde abgelegt, so gibt die Zeitvergleichseinrichtung 8 diese Signale nur an die Intensitätsvergleichseinrichtung 9 zur weiteren Verarbeitung weiter. Innerhalb der Intensitätsvergleichseinrichtung 9 vergleicht ein Komparator 10 die Intensitäten der wenigstens zwei Störsignale und gibt hiervon das größte Signal oder alle Signale nur in dem Fall weiter, wenn das größte der Störsignale sich von den übrigen Signalen um einen Faktor unterscheidet, der größer ist als ein bestimmter, mittels einer Eingabevorrichtung 32 eingebbarer Faktor, der beispielsweise zehn betragen kann.

Wird zum Beispiel eine Zeitspanne von einer Mikrosekunde mittels der Zeiteingabevorrichtung 24 und ein Faktor 10 mittels der Eingabevorrichtung 32 eingegeben, so werden zwei Störsignale, die in einem zeitlichen Abstand von einer halben Mikrosekunde in den Speichern 20, 21 eintreffen, an die Intensitätsvergleichseinrichtung 9 und an den Komparator 10 weitergeleitet. Unterscheiden sich die Intensitäten der beiden Signale um einen Faktor, der größer ist als zehn, so werden sie oder nur das größte von ihnen an die Bewertungs- und Warneinrichtungen 25, 26 bzw. an die Sicherheitsschalter 28, 29 und an die zusätzliche Analyseeinrichtung 31 weitergeleitet.

Unterscheiden die beiden genannten Signale sich nicht um einen Faktor zehn sondern nur um einen Faktor fünf, so werden die beiden Störsignale in dem gegebenen Beispiel nicht ausgegeben.

Das Meßsystem erfüllt somit die Aufgabe, Störsignale nur dann auszugeben, wenn sie mit einer bestimmten Mindestwahrscheinlichkeit auf Störungen innerhalb der Metallkapselung der gekapselten Hochspannungsschaltanlage und nicht auf Störungen außerhalb der Anlage zurückzuführen sind. Somit ist die Verarbeitung von Signalen von vermeidbaren Fehlalarmen entlastet. Es steht daher genug Zeit zur Verfügung, um die tatsächlich wichtigen Störsignale gründlich zu analysieren und den Störungen nachzugehen.

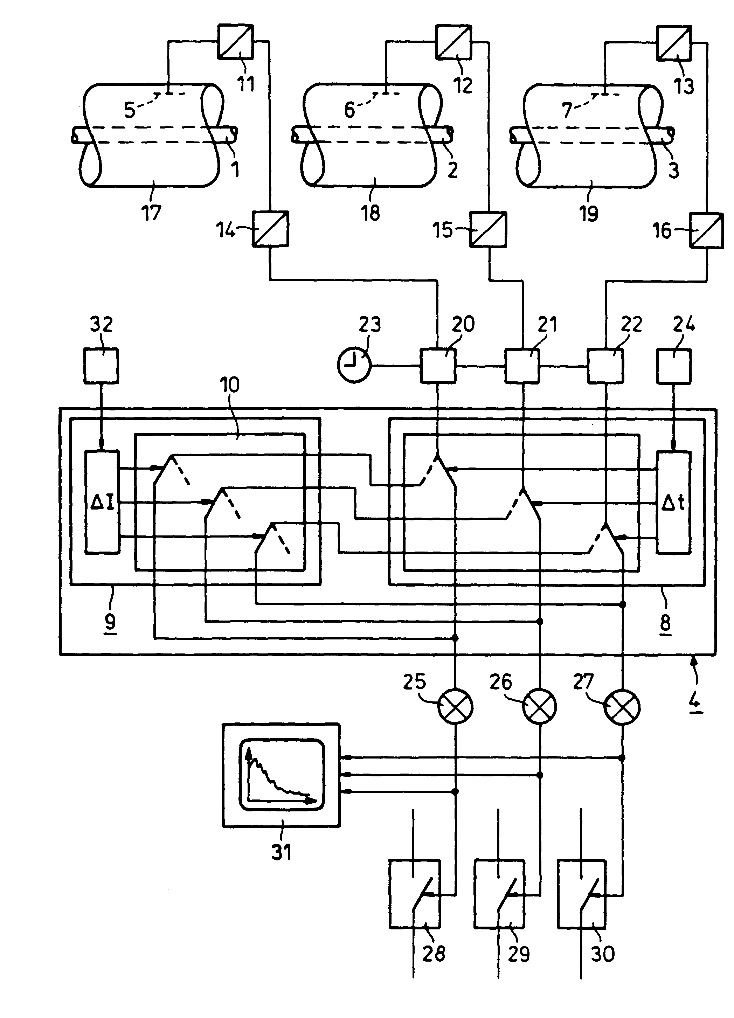

## Patentansprüche

1. Meßsystem für Störsignale in Form von elektromagnetischen Wellen in gekapselten Hochspannungsschaltanlagen, die wenigstens zwei einphasig gekapselte Pole (1, 2, 3) aufweisen, welches wenigstens einen Sensor für jede Phase zur Erfassung von Störsignalen und eine mit den Sensoren (5, 6, 7) verbundene Detektoreinrichtung (4) zur Ausgabe eines Signals im Falle einer Störung aufweist,
**gekennzeichnet durch**
eine Zeitvergleichseinrichtung (8), die die unmittelbare, ohne Durchlaufen anderer Analysestationen erfolgende Ausgabe eines Signals sperrt, falls die Zeitdifferenz des Eintreffens zweier Störsignale von Sensoren (5, 6, 7) verschiedener Phasen bei der Detektoreinrichtung (4) eine bestimmte, insbesondere einstellbare Zeitspanne unterschreitet.

2. Meßsystem nach Anspruch 1,
**dadurch gekennzeichnet,** daß
die Detektoreinrichtung (4) eine Intensitatsvergleichseinrichtung (9) enthält, an die die Zeitvergleichseinrichtung (8) die Störsignale weiterleitet, wenn die Zeitdifferenz des Eintreffens zweier Störsignale der unterschiedlichen Phasen bei der Detektoreinrichtung (4) kleiner ist als die Zeitspanne, und die einen Komparator (10) zum Vergleich der Intensitäten der verschiedenen Störsignale enthält, welcher die Ausgabe eines Signals bewirkt, falls das Intensitätsverhältnis des größten Störsignals zu jedem der übrigen von den Sensoren (5, 6, 7) erfaßten Störsignale einen bestimmten, insbesondere einstellbaren Faktor überschreitet.

3. Meßsystem nach Anspruch 1 oder 2,
**dadurch gekennzeichnet,** daß
jedem Sensor (5, 6, 7) ein Frequenzumsetzer (11, 12, 13) zur Umsetzung des von dem jeweiligen Sensor (5, 6, 7) erfaßten Hochfrequenzsignals in ein Niederfrequenzsignal nachgeschaltet ist.

4. Meßsystem nach Anspruch 3,
**dadurch gekennzeichnet,** daß
jedem Frequenzumsetzer (11, 12, 13) ein Intensitätsdetektor nachgeschaltet ist.

5. Verfahren zur Erfassung von Störsignalen in Form von elektromagnetischen Wellen in einer wenigstens zweipoligen, einphasig gekapselten Hochspannungsschaltanlage mittels eines Meßsystems, wobei mittels einer mit Sensoren (5, 6, 7), welche unterschiedlichen Phasen zugeordnet sind, verbundenen Detektoreinrichtung die Ausgabe eines Signals bewirkt wird, wenn wenigstens einer der Sensoren (5, 6, 7) ein Störsignal abgibt,
**dadurch gekennzeichnet,** daß
von einer Zeitvergleichseinrichtung die unmittelbare, ohne Durchlaufen anderer Analysestationen erfolgende Ausgabe eines Signals gesperrt wird, wenn die Zeitdifferenz des Eintreffens zweier Störsignale von verschiedenen Phasen bei der Detektoreinrichtung (4) eine bestimmte, insbesondere einstellbare Zeitspanne unterschreitet.

6. Verfahren nach Anspruch 5,
**dadurch gekennzeichnet,** daß
in dem Fall, daß die Zeitdifferenz des Eintreffens zweier Störsignale der verschiedenen Phasen bei der Detektoreinrichtung (4) eine einstellbare Zeitspanne unterschreitet, die Intensitäten der betreffenden Störsignale miteinander verglichen werden und daß in dem Fall, daß das Intensitätsverhaltnis des größten der Störsignale zu jedem der übrigen von den Sensoren erfaßten Störsignale einen bestimmten, insbesondere einstellbaren Faktor überschreitet, unabhängig von der Zeitdifferenz ein Signal ausgegeben wird.

## Claims

1. Measuring system for interference signals in the form of electromagnetic waves in enclosed high-voltage switchgear which have at least two phase, segregated poles (1, 2, 3), which measuring system has at least one sensor for each phase for the detection of interference signals and a detector device (4) connected to the sensors (5, 6, 7) for the output of a signal in the event of interference, characterised by a time comparing device (8), which blocks the direct output of a signal, which output takes place without passing through other analysis stations, if the time difference between the arrival at the detector device (4) of two interference signals of sensors (5, 6, 7) of different phases falls below a certain, in particular adjustable, time span.

2. Measuring system according to claim 1, characterised in that the detector device (4) contains an intensity comparing device (9), to which the time comparing device (8) passes on the interference signals if the time difference between the arrival at the detector device (4) of two interference signals of different phases is less than the time span and which contains a comparator (10) for comparing the intensities of the different interference signals, which comparator effects the output of a signal if the intensity ratio of the largest interference signal to each of the other interference signals detected by the sensors (5, 6, 7) exceeds a certain, in particular adjustable, factor.

3. Measuring system according to claim 1 or 2, characterised in that connected downstream of each sensor (5, 6, 7) is a frequency converter (11, 12, 13) for converting the high-frequency signal detected by the respective sensor (5, 6, 7) into a low-frequency signal.

4. Measuring system according to claim 3, characterised in that there is connected downstream of each frequency converter (11, 12, 13) an intensity detector.

5. Method for detecting interference signals in the form of electromagnetic waves in an at least two pole, phase-segregated high-voltage switchgear by means of a measuring system, with the output of a signal being effected by means of a detector device, which is connected to sensors (5, 6, 7) which are allocated to different phases, if at least one of the sensors (5, 6, 7) outputs an interference signal, characterised in that the direct output of a signal, which output takes place without passing through other analysis stations, is blocked by a time comparing circuit if the time difference between the arrival at the detector device (4) of two interference signals of different phases falls below a certain, in particular adjustable, time span.

6. Method according to claim 5, characterised in that in the event that the time difference between the arrival at the detector device (4) of two interference signals of different phases falls below an adjustable time span, the intensities of the respective interference signals are compared with each other, and in that in the event that the intensity ratio of the largest of the interference signals to each of the other interference signals detected by the sensors exceeds a certain, in particular adjustable, factor, a signal is output irrespective of the time difference.

## Revendications

1. Système de mesure pour des signaux parasites sous forme d'ondes électromagnétiques dans des appareillages blindés de commutation haute tension, qui comportent au moins deux pôles (1, 2, 3) à blindage monophasé, le système de mesure comprenant au moins un capteur pour chaque phase, destiné à relever des signaux parasites, et un dispositif de détection (4) relié aux capteurs (5, 6. 7), pour envoyer un signal en présence d'une situation parasite, caractérisé par un dispositif de comparaison de temps (8) qui bloque l'envoi direct d'un signal, sans passage dans d'autres postes d'analyse, dans le cas où la différence de temps entre l'entrée de deux signaux parasites de capteurs (5, 6, 7) de phases différentes dans le dispositif de détection (4), est inférieure à un intervalle de temps déterminé, notamment réglable.

2. Système de mesure selon la revendication 1, caractérisé en ce que le dispositif de détection (4) comprend un dispositif de comparaison d'intensité (9) auquel le dispositif de comparaison de temps (8) transmet les signaux parasites lorsque la différence de temps de l'entrée de deux signaux parasites des phases différentes dans le dispositif de détection (4) est inférieure à l'intervalle de temps considéré, et qui comprend un comparateur (10) destiné à la comparaison des intensités des différents signaux parasites et provoquant l'envoi d'un signal dans le cas où le rapport des intensités du plus grand signal parasite à chacun des autres signaux parasites relevés par les capteurs (5, G, 7) est supérieur à un facteur déterminé, notamment réglable.

3. Système de mesure selon la revendication 1 ou 2, caractérisé en ce qu'en aval de chaque capteur (5, 6, 7) est monté un changeur de fréquence (11, 12, 13) destiné à convertir le signal haute fréquence relevé par le capteur (5, 6, 7) respectif en un signal basse fréquence.

4. Système de mesure selon la revendication 3, caractérisé en ce qu'en aval de chaque changeur de fréquence (11, 12, 13) est monté un détecteur d'intensité.

5. Procédé destiné à relever des signaux parasites sous la forme d'ondes électromagnétiques dans un appareillage de commutation haute tension à blindage monophasé et comportant au moins deux pales, au moyen d'un système de mesure, procédé selon lequel on provoque, à l'aide d'un dispositif de détection relié à des capteurs (5, 6, 7), qui sont affectés à des phases différentes, l'envoi d'un signal lorsque l'un au moins des capteurs (5. 6, 7) envoie un signal parasite, caractérisé en ce qu'un dispositif de comparaison de temps (8) bloque l'envoi direct d'un signal, sans passage dans d'autres postes d'analyse, lorsque la différence de temps entre l'entrée de deux signaux parasites de phases différentes dans le dispositif de détection (4), est inférieure à un intervalle de temps déterminé, notamment réglable.

6. Procédé selon la revendication 5, caractérisé en ce que dans le cas où la différence de temps entre l'entrée de deux signaux parasites des phases différentes dans le dispositif de détection (4), est inférieure à un intervalle de temps réglable, les intensités des signaux parasites considérés sont comparées l'une à l'autre, et en ce que dans le cas où le rapport des intensités du plus grand signal parasite à chacun des autres signaux parasites relevés par les capteurs est supérieur à un facteur déterminé, notamment réglable, on envoi un signal indépendamment de la différence de temps.
